# EUROPEAN PATENT APPLICATION

(11) **EP 2 385 550 A1**
(43) Date of publication of application: **09.11.2011**
(21) Application number: 11174039.5
(22) Date of filing: 24.10.2008
(51) Int. Cl.: H01L 23/495

(54) **Semiconductor device and its fabrication process**

(30) Priority: 26.10.2007 JP 2007278437
(62) Divisional of application: 08253481.9
(71) Applicant: Renesas Electronics Corporation, Kanagawa 211-8668 (JP)
(72) Inventor: Okura, Yasutaka, Tokyo (JP); Iwasaki, Tomio, Tokyo (JP); Terasaki, Takeshi, Tokyo (JP)
(74) Representative: Calderbank, Thomas Roger

(57) **Abstract**

A technique capable of preventing whiskers which are generated in a plating film formed on the surface of each of leads of a semiconductor device is provided. Particularly, a technique capable of preventing generation of whiskers in a plating film containing tin as a primary material and not containing lead is provided. The plating film formed on the surface of the lead is formed so that a particular plane orientation among plane orientations of tin constituting the plating film is parallel to the surface of the lead. Specifically, the plating film is formed so that the (001) plane of tin is parallel to the surface of the lead. Thus, the coefficient of thermal expansion of tin constituting the plating film can be made to be lower than a coefficient of thermal expansion of the copper constituting the lead.

## Description

The present invention relates to a semiconductor device and its fabrication process. More particularly, the present invention relates to a technique effectively applied to a semiconductor device using a plating film containing tin (Sn) as a primary material and not containing lead (Pb), and to fabrication of the same.

IEEE TRANSACTIONS ON ELECTRONICS PACKAGING MANUFACTURING, pp 265-273, VOL. 29, NO. 4, OCTOBER 2006 (Non-Patent Document 1) describes a review about needle-like crystals (whiskers) generated in a plating film containing tin as a primary component and not containing lead. In this review, growth of whiskers generated in tin is discussed on the basis of stress (strain energy density) generated in the fine structure of tin. An overview thereof is as the following. Modeling by the finite element method (FEM) in consideration of elastic anisotropy and anisotropy and plasticity relating to thermal expansion generated in tin having a β-Sn structure has been established. A Voronoi diagram is used for generating a geometric pattern of grains (crystal grains) of tin that is coating a lead frame composed of copper. Crystal orientations are assigned to grains of tin in a model (finite element method) by using the X-ray diffraction measurement method with respect to a sample. This model is applied to leads of a package plated by tin under a thermal cycling test. Then, strain energy densities (SED) are calculated for the respective grains. As a result, it was observed that there was a tendency that the higher the calculated strain energy density the sample has, the longer the generated whiskers become and also the higher the generation density of the whiskers is. Accordingly, the document states that the technique of measuring crystal structures of tin plating films by using the X-ray diffraction measurement method and analyzing the measurement result in combination with the FEM model can be an important index for studying the whiskers generated in the tin plating film.

As a mode of a semiconductor device, there is a technique of mounting a semiconductor chip on a tab and electrically connecting the semiconductor chip mounted on the tab with a plurality of leads by wires. And, the semiconductor device has a structure in which the semiconductor chip is resin-sealed by a sealant body and part of each of the plurality of leads is exposed from the sealant body. The semiconductor device having such a structure is mounted on a mounting board by using the leads exposed from the sealant.

The leads of the semiconductor device and terminals of the mounting board are connected, for example, by using solder. At this point, generally, plating films are formed on the surfaces of the leads to improve the wettability of the leads and the solder or to prevent corrosion or oxidation of the leads because the primary material of the leads is generally copper. From the viewpoint of realization of this objective and from the viewpoint of cost reduction, a film containing tin as a primary material is used as the plating film.

However, in the plating film containing tin as a primary material, formation of needle-like crystals called whiskers has been a problem. More specifically, it has become apparent that the structure in which whiskers having lengths of several tens of µm to several hundreds of µm are projecting from the surface of the plating film. When such whiskers are generated, the situation that adjacent leads are electrically connected to each other by the whiskers formed on the plating films occurs. This means that short-circuit malfunction occurs in the semiconductor device since the adjacent leads are electrically connected to each other by the whiskers. Therefore, prevention of generation of the whiskers is required for the plating film containing tin as a primary material.

The mechanism of the generation of whiskers is caused by compressive stress generated in the plating film. More specifically, it is conceived that, when compressive stress is applied to the plating film, part of the plating film that cannot withstand the compressive stress any more projects, thereby generating whiskers. It has been known that the compressive stress serving as the cause of generation of whiskers is generated by three causes.

A first cause is the compressive stress that is generated when a compound of copper constituting the lead and tin constituting the plating film is formed in the plating film so that the volume dependent on the compounds expands. A second cause is the compressive stress that is generated when a load is applied to the plating film from outside. Furthermore, a third cause is the compressive stress that is generated when it is at a high temperature in the case where a thermal load by repetitive application of a high temperature and a low temperature is applied, because the coefficient of thermal expansion of the plating film (tin) is higher than that of the lead (copper).

The whiskers are generated in the plating film due to the compressive stress generated by the abovedescribed causes. In conventional techniques, in order to prevent the whiskers generated in the plating film containing tin as a primary material, lead (Pb) elements has been introduced into the plating film. Although the detailed mechanism thereof is unknown, generation of whiskers in the plating film can be prevented by adding lead to the plating film containing tin as a primary material.

However, in recent years, since lead (Pb) is harmful when it outflows to the environment, various products have been made to be free from lead, and semiconductor devices are also required to be lead-free. Therefore, although lead has been added to the plating film containing tin as a primary material in order to prevent generation of whiskers, the trend not to add lead to the plating film has become stronger in recent years. Along with such lead-free trend, generation of whiskers in the plating film containing tin as a primary component has become apparent again as a problem. Particularly, the pitches between adjacent leads have become narrower along with miniaturization and integration of semiconductor devices (for example, QFP (Quad Flat Package)) in recent years, and therefore, the whiskers generated in the plating film have become a critical issue.

A preferred aim of the present invention is to provide a technique capable of preventing whiskers generated in a plating film that is formed on a surface of a lead of a semiconductor device. More particularly, a preferred aim of the present invention is to provide a technique capable of preventing generation of whiskers in a plating film containing tin as a primary material and not containing lead.

The above and other aims and novel characteristics of the present invention will be apparent from the description of this specification and the accompanying drawings.

The typical ones of the inventions disclosed in this application will be briefly described as follows.

A semiconductor device according to a typical embodiment comprises: (a) a semiconductor chip; (b) a plurality of leads electrically connected with the semiconductor chip and containing copper as a primary material; (c) a plating film formed on a surface of each of the plurality of leads, the plating film containing tin as a primary material and not containing lead; and (d) a sealant sealing the semiconductor chip. And, part of each of the plurality of leads is exposed from the sealant, and a coefficient of thermal expansion in an in-plane direction of the plating film is smaller than a coefficient of thermal expansion of the copper.

Consequently, the coefficient of thermal expansion in a surface of the plating film becomes smaller than the coefficient of thermal expansion of the copper (lead); thus, even when thermal load by repetitive application of high temperatures and low temperatures is applied, compressive stress can be prevented from acting on the surface of the plating film when it is put at a high temperature. That is, since the coefficient of thermal expansion in the surface of the plating film is smaller than the coefficient of thermal expansion of the copper, the plating film is pulled by the lead containing copper as a primary material. Thus, tensile stress acts on the plating film instead of compressive stress; therefore, generation of whiskers caused by compressive stress can be prevented.

In addition, a fabrication process of a semiconductor device according to a typical embodiment comprises: (a) preparing a lead frame containing copper as a primary material; (b) forming a plating film containing tin as a primary material and not containing lead on a surface of each of a plurality of leads formed to the lead frame; (c) mounting a semiconductor chip on a tab of the lead frame; (d) connecting the semiconductor chip with the plurality of leads formed to the lead frame by wires; (e) forming a sealant body by sealing the semiconductor chip; and (f) cutting the lead frame to separate the sealant body into pieces. Here, the plating film is formed so that a coefficient of thermal expansion in an in-plane direction of the plating film is smaller than a coefficient of thermal expansion of the copper constituting the plurality of leads.

Consequently, tensile stress acts on the plating film instead of compressive stress when it is put at a high temperature; therefore, generation of whiskers caused by compressive stress can be prevented.

The effects obtained by typical aspects of the present invention will be briefly described below.

The coefficient of thermal expansion in the surface of the plating film is smaller than the coefficient of thermal expansion of copper; therefore, generation of whiskers caused by compressive stress can be prevented.

In the drawings:
FIG. 1 is a diagram showing an external appearance of a semiconductor device according to a first embodiment of the present invention;
FIG. 2 is a cross-sectional view showing a cross section of FIG. 1 taken along the line A-A;
FIG. 3 is a cross-sectional view showing an enlarged part of a lead formed in the semiconductor device shown in FIG. 2;
FIG. 4 is a diagram for describing plane orientations;
FIG. 5 is a diagram showing a (001) plane;
FIG. 6 is a diagram showing a (110) plane;
FIG. 7 is a diagram showing a crystal structure (β-Sn structure) of tin;
FIG. 8 is a table explaining that a coefficient of thermal expansion of tin differs depending on plane orientations;
FIG. 9 is a cross-sectional view showing a plating film having a single-crystal structure formed on the lead;
FIG. 10 is a cross-sectional view showing a plating film having a polycrystalline structure formed on the lead;
FIG. 11 is a cross-sectional view showing an example of forming a gold film between the lead and the plating film;
FIG. 12 is a diagram showing an array of gold atoms forming the (001) plane;
FIG. 13 is a diagram showing an array of tin atoms forming the (001) plane;
FIG. 14 is a diagram showing the array of gold atoms and tin atoms in an interface of the gold film and the plating film;
FIG. 15 is a diagram showing a fabrication step of the semiconductor device according to the first embodiment to describe dicing;
FIG. 16 is a diagram showing a fabrication step of the semiconductor device continued from FIG. 15 to show a step of mounting semiconductor chips on a lead frame;
FIG. 17 is a diagram showing a fabrication step of the semiconductor device continued from FIG. 16 to show a step of electrically connecting the semiconductor chips with leads by wires;
FIG. 18 is a diagram showing a fabrication step of the semiconductor device continued from FIG. 17 to show a step of sealing the semiconductor chips by a resin;
FIG. 19 is a diagram showing an external appearance of the semiconductor device according to the first embodiment;
FIG. 20 is a diagram showing a result of X-ray diffraction measurement of tin crystals in a powdery state to show a relation between a crystal plane spacing and a relative intensity of X-ray diffraction;
FIG. 21 is a diagram showing a result of X-ray diffraction measurement of tin crystals forming a plating film to show a relation between a crystal plane spacing and a relative intensity of X-ray diffraction;
FIG. 22 is a cross-sectional view showing a constitution of a plating film formed on a lead according to a second embodiment; and
FIG. 23 is a cross-sectional view showing a constitution of a plating film formed on a lead according to the second embodiment.

In the embodiments described below, the invention will be described in a plurality of sections or embodiments when required as a matter of convenience. However, these sections or embodiments are not irrelevant to each other unless otherwise stated, and the one relates to the entire or a part of the other as a modification example, details, or a supplementary explanation thereof.

Also, in the embodiments described below, when referring to the number of elements (including number of pieces, values, amount, range, and the like), the number of the elements is not limited to a specific number unless otherwise stated or except the case where the number is apparently limited to a specific number in principle. The number larger or smaller than the specified number is also applicable.

Further, in the embodiments described below, it goes without saying that the components (including element steps) are not always indispensable unless otherwise stated or except the case where the components are apparently indispensable in principle.

Similarly, in the embodiments described below, when the shape of the components, positional relation thereof, and the like are mentioned, the substantially approximate and similar shapes and the like are included therein unless otherwise stated or except the case where it can be conceived that they are apparently excluded in principle. The same goes for the numerical value and the range described above.

Also, in some drawings used in the embodiments, hatching is used even in a plan view so as to make the drawings easy to see.

### (First Embodiment)

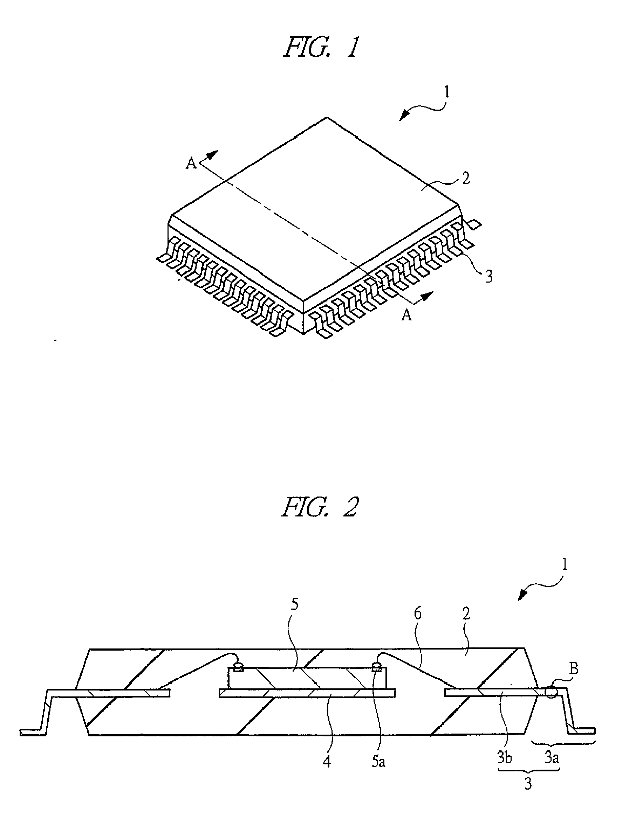

FIG. 1 is a perspective view showing an external appearance of a semiconductor device according to a first embodiment. The package configuration of the semiconductor device according to the first embodiment is a QFP (Quad Flat Package). As shown in FIG. 1, the semiconductor device 1 according to the first embodiment is covered by a resin (sealant) 2 having a shape of a rectangular parallelepiped, and leads 3 are projecting from four side surfaces of the resin 2. The lead 3 has a structure bent in an L shape.

FIG. 2 is a cross-sectional view showing a cross section taken along the line A-A of FIG. 1. As shown in FIG. 2, the lead 3 comprises an outer lead 3a projecting from the side surface of the resin 2 and an inner lead 3b formed in the inside of the resin 2. A tab 4 is formed at a center part sandwiched by the inner leads 3b at the left and the right (surrounded by the plurality of inner leads 3b), and a semiconductor chip 5 is disposed on the tab 4. On the semiconductor chip 5, circuit elements such as MISFETs (Metal Insulator Semiconductor Field Effect Transistors) and wirings are formed, and bonding pads 5a are formed on the uppermost layer of the semiconductor chip 5. The top of each bonding pad 5a is connected to a wire 6, and the wire 6 is connected to the inner lead 3b.

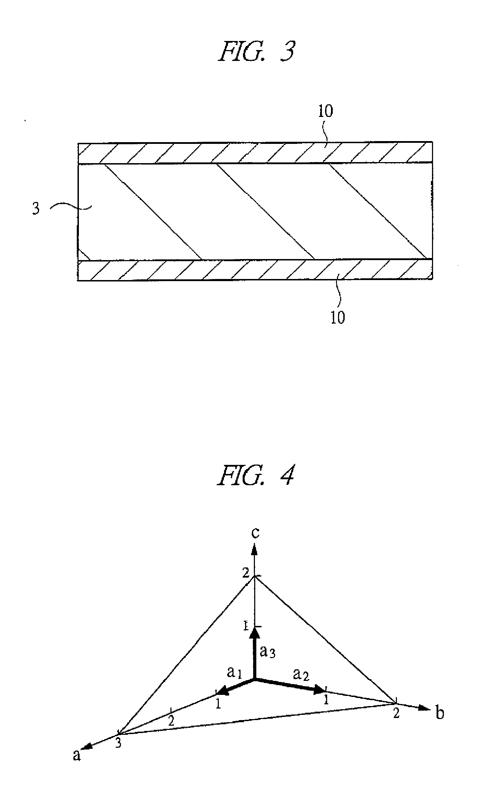

FIG. 3 is a diagram showing the region B in FIG. 2 being enlarged. More specifically, FIG. 3 is a cross-sectional view enlarging the lead 3 (outer lead 3a) exposed from the resin 2. As shown in FIG. 3, a plating film 10 is formed on a surface (including the back surface) of the lead 3. The lead 3 comprises copper as a primary material, and the plating film 10 is formed by a film containing tin as a primary material and not containing lead. The plating film 10 is formed on the lead 3 in this manner, and the plating film 10 is formed on the surface of the lead 3, for example, for the reasons described below.

The semiconductor device 1 shown in FIG. 1 is mounted on a mounting board, and, at this point, terminals formed on the mounting board and the leads 3 formed on the semiconductor device 1 are electrically connected to each other. Solder is used in the electrical connection between the terminals and the leads 3. Therefore, the leads 3 comprising copper can be directly connected with the terminals by solder; however, the plating films 10 are formed on the surfaces of the leads 3 in order to improve the wettability of the leads 3 with respect to the solder. When the plating films 10 are formed on the surfaces of the leads 3 in this manner, the wettability between the leads 3 and the solder is improved, and the connection reliability of the leads 3 and the terminals on the mounting board via the solder can be improved. A film containing tin, which has a good wettability with solder, as a primary material is used as the plating film 10. Furthermore, when the plating films 10 are formed on the surfaces of the leads 3, corrosion and oxidation of the leads 3 can be prevented.

Depending on the operating environment, the semiconductor device 1 is exposed to thermal cycles of a state in which the temperature is higher than room temperature and a state in which the temperature is lower than normal temperature. In other words, thermal load is applied to the semiconductor device 1. Herein, the plating film 10 is formed on the surface of the lead 3, where the lead 3 contains copper as a primary component, while the plating film 10 contains tin as a primary material. Therefore, when the thermal cycles are applied to the semiconductor device 1, some stress acts on copper and tin since copper and tin have different coefficients of thermal expansion. For example, the coefficient of thermal expansion of copper is 17.2x10⁻⁶ K⁻¹, and a general coefficient of thermal expansion of tin is 24.3x10⁻⁶ K⁻¹. As described above, the general coefficient of thermal expansion of tin is higher than the coefficient of thermal expansion of copper. For example, when the semiconductor device 1 is put in a high-temperature state, tin constituting the plating film 10 expands more than the expansion of the copper constituting the lead 3. Therefore, the plating film 10 gets to expand more than the lead 3; however, since the copper of the lead 3 cannot correspondingly expand, compressive stress is generated in the plating film 10 due to restriction from the lead 3. Since the general coefficient of thermal expansion of tin is higher than the coefficient of thermal expansion of copper in this manner, compressive stress acts on the plating film 10 when it is put at a high temperature. Furthermore, there is a tendency that the atoms constituting crystals readily diffuse due to thermal diffusion in this high-temperature state; therefore, when the compressive stress is applied to the plating film 10, needle-like crystals (whiskers) are readily generated in the plating film 10. In other words, the whiskers are protruded from the plating film 10. The lengths of the whisker are, for example, several tens of µm to several hundreds of µm.

In the semiconductor device 1, the plurality of leads 3 are exposed from the resin 2, and the distances between adjacent leads 3 have become narrower due to miniaturization and high integration of the semiconductor device 1. Consequently, when whiskers are formed in the plating films 10 formed on the surfaces of the leads 3, the adjacent leads 3 are electrically connected to each other by the whiskers, and a short-circuit malfunction occurs in the semiconductor device 1. Therefore, generation of the whiskers caused by the compressive stress in the case of a high temperature has to be prevented. Note that, in the case of a low temperature of thermal cycles, the plating film 10 and the lead 3 contract, and the plating film 10 contracts more than the lead 3 does since the coefficient of thermal expansion of tin constituting the plating film 10 is higher than the coefficient of thermal expansion of copper constituting the lead 3. Therefore, tensile stress acts on the plating film 10. Thus, in the case of a low temperature of the thermal cycles, generation of whiskers is not a problem since compressive stress does not act on the plating film 10. For the reasons described above, it can be understood that it is required to prevent the whiskers to be generated in the plating film 10 at a high temperature of the thermal cycles.

As a conventional technique, lead (Pb) has been added to the plating film containing tin as a primary material in order to prevent generation of the whiskers. Although the detailed mechanism thereof is unknown, when the plating film is made to contain lead, generation of whiskers in the plating film can be prevented.

However, recently, since lead is harmful when it outflows to the environment, various products are becoming free from lead, and the trend of lead-free has been also required for semiconductor devices. Therefore, although lead has been added to the plating film containing tin as a primary material in order to prevent generation of whiskers, the trend of not adding lead to the plating film has become stronger in recent years. Along with such a lead-free trend, generation of whiskers in the plating film containing tin as a primary component has become apparent again as a problem.

Therefore, the first embodiment is to prevent the whiskers generated in the plating film 10 containing tin as a primary component and not containing lead with focusing on a matter described below. This matter will be described. First, a cause of the generation of whiskers is the compressive stress generated in the plating film 10 at a high temperature of the thermal cycles. This compressive stress is generated since the coefficient of thermal expansion of the plating film 10 is higher than the coefficient of thermal expansion of the lead 3. Therefore, in the first embodiment, the coefficient of thermal expansion of the plating film 10 is configured to be lower than the coefficient of thermal expansion of the lead 3. Consequently, in the case of a high temperature of the thermal cycles, the lead 3 expands more than the plating film 10 does, and tensile stress acts on the plating film 10 instead of compressive stress. Therefore, since compressive stress does not act on the plating film 10, generation of the whiskers formed in the plating film 10 due to the compressive stress at a high temperature can be prevented.

An issue herein is that the primary material of the plating film 10 is tin and that the primary material of the lead 3 is copper. In other words, a general coefficient of thermal expansion of tin is higher than the coefficient of thermal expansion of copper. Regardless of this fact, it is a problem that whether it is possible to make the coefficient of thermal expansion of the plating film 10 containing tin as a primary material lower than the coefficient of thermal expansion of the lead 3 containing copper as a primary material. The crystal structure of tin has two types; an α-Sn structure and a β-Sn structure. The α-Sn structure is a crystal structure at low temperatures; and, in an operation temperature range of the semiconductor device 1 that is in the vicinity of room temperature, the crystal structure of tin is the β-Sn structure. The β-Sn structure has a characteristic that the coefficient of thermal expansion differs depending on the plane orientations. The first embodiment focuses on the anisotropy that the coefficient of thermal expansion differs depending on the plane orientation in the crystal structure of tin. More specifically, a general plating film comprising tin has a polycrystalline structure, and a plurality of grains (crystal grains) are contained in the plating film 10. The grains formed in the plating film are directed toward various plane orientations, respectively. More specifically, the general plating film 10 is formed by the grains directed toward various plane orientations. In other words, the individual grains constituting the plating film 10 are not in the state (single crystal) to be aligned in one certain plane orientation. Therefore, the grains directed toward various plane orientations have different coefficients of thermal expansion, respectively, and the coefficient of thermal expansion of the plating film comprising these grains is an average of the coefficients of thermal expansion of the grains. In other words, there is an assumption that the general plating film 10 is formed by a film equally containing grains directed toward various plane orientations, and the coefficient of thermal expansion of tin that is 24.3x10⁻⁶ K⁻¹ is an average of coefficients of thermal expansion of the equally contained grains having different plane orientations. Accordingly, the crystals of tin have different values depending on the directions of the plane orientation that is parallel to the surface. The first embodiment focuses on the point that the coefficient of the plane film 10 becomes lower than the coefficient of thermal expansion of copper when the direction of the plane orientation parallel to the surface of the plane film 10 has a particular plane orientation.

First, the idea of plane orientations will be described before describing crystal structures of tin. A position and direction of a crystal plane in which atoms are present are determined by three points which are not on one straight line on the crystal plane. When the coordinates of the three points are given by using lattice constants a₁, a₂, and a₃ as units, the crystal plane can be determined. In the crystal plane, the direction of the plane can be expressed by indices determined by a rule described below. More specifically, the lengths that the crystal plane separates the crystal axes are expressed by using the lattice constants a₁, a₂, and a₃ as units. Then, inverse numbers of the numbers expressed by using the lattice constants a₁, a₂, and a₃ as units are obtained and reduced to three integer numbers having a same proportion. The result thereof is parenthesized to provide (hkl), and this (hkl) serves as a plane index of a crystal plane. Thus, (hkl) represents a crystal plane.

An example of a crystal plane specifically specified by (hkl) will be described. FIG. 4 is a diagram showing a certain crystal plane. In FIG. 4, this plane is intersecting with a crystal axis "a" at 3a₁. Similarly, it intersects with a crystal axis "b" at 2a₂ and intersects with a crystal axis "c" at 2a₃. Therefore, when the lengths the crystal plane separates the crystal axes are expressed by the lattice constants a₁, a₂, and a₃, they are (3, 2, 2). The inverse numbers of the combination of these numbers are (1/3, 1/2, 1/2). Therefore, the combination of minimum integer numbers having the same proportion as the combination of these inverse numbers is (2, 3, 3). Thus, an index of the crystal plane is (233).

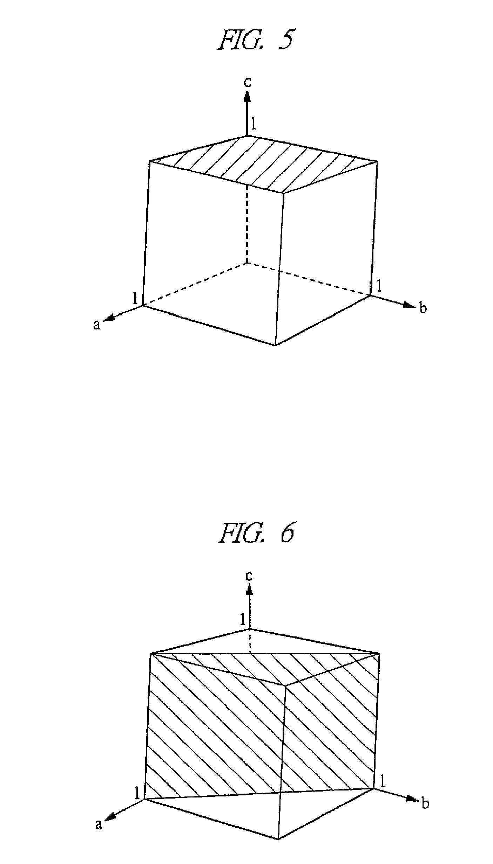

Furthermore, an example of a crystal plane specified by (hkl) will be described. FIG. 5 shows a (001) plane of a cubic lattice. More specifically, since the crystal plane shown with diagonal lines does not intersect with the crystal axis a, it can be said that it intersects with the crystal axis a at ∞a₁. Similarly, since the plane does not intersect with the crystal axis b, the plane intersects with the crystal axis b at ∞a₂ and intersects with the crystal axis c at 1a₃. Therefore, when the lengths that the crystal plane separates the crystal axes are expressed by the lattice constants a₁, a₂, and a₃, they are (∞, ∞, 1). The inverse numbers of the combination of these numbers are (1/∞ (=0), 1/∞ (=0), 1). Therefore, the combination of minimum integer numbers having the same proportion as the combination of the inverse numbers is (0, 0, 1). Thus, an index of the crystal plane is (001).

FIG. 6 shows a (110) plane of a cubic lattice. More specifically, it can be said that the crystal plane shown with diagonal lines intersects with the crystal axis a at 1a₁. Similarly, it can be also said that the plane intersects with the crystal axis b at 1a₂ and intersects with the crystal axis c at ∞a₃ since the plane does not intersect with the crystal axis c. Therefore, when the lengths that the crystal plane separates the crystal axes are expressed by the lattice constants a₁, a₂, and a₃ , they are (1, 1, ∞) . The inverse numbers of the combination of these numbers are (1, 1, 1/∞ (=o)). Therefore, the combination of minimum integer numbers having the same proportion as the combination of the inverse numbers is (1, 1, 0). Thus, an index of the crystal plane is (110).

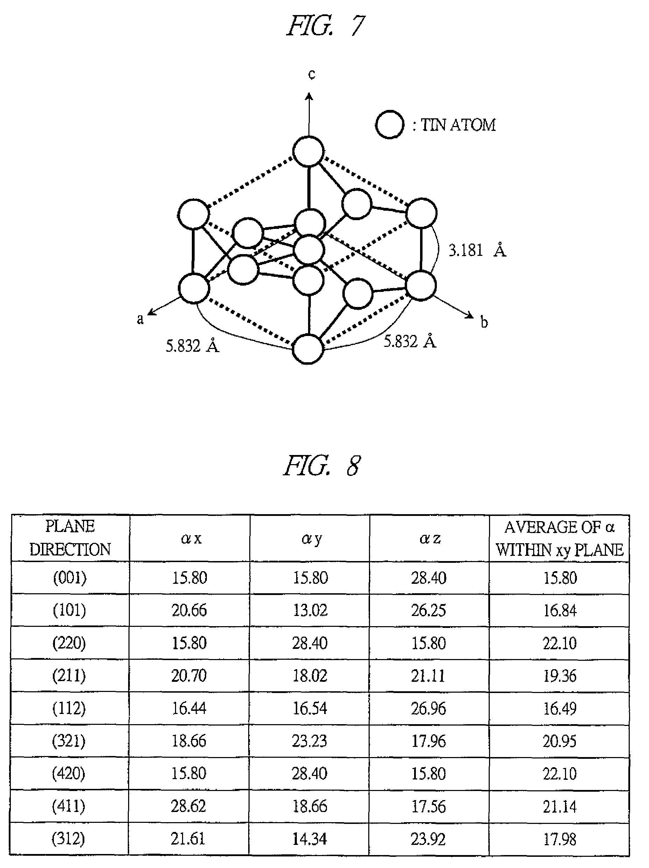

It can be understood that the crystal planes can be expressed by the indices (hkl) of a combination of integer numbers in the abovedescribed manner. Subsequently, the crystal structure of tin will be described. FIG. 7 is a diagram showing the β-Sn structure of tin. As shown in FIG. 7, the β-Sn structure is a complex structure. The lattice constant in the direction of the crystal axis a and the lattice constant in the direction of the crystal axis b are 5.832 Å, and the lattice constant in the direction of the crystal axis c is 3.181 Å. In the crystal structure shown in FIG. 7, for example, various plane orientations such as (001), (101), (220), (211), (112), (321), (420), (411), and (312) are present as the (hkl) planes. In the β-Sn structure having the plurality of different plane orientations in this manner, the coefficients of thermal expansion in the directions of the crystal axes are different to the respective plane orientations.

Examples of these are shown in FIG. 8. Coefficients of thermal expansion αx, αy, and αz in FIG. 8 represent coefficients of thermal expansion in an x-axis direction, y-axis direction, and z-axis direction, respectively. Herein, the xyz coordinate system is a coordinate system different from the coordinate system according to the crystal axes a, b, and c. More specifically, the coordinate system according to the crystal axes a, b, and c are the coordinate system that determines the plane orientations of crystal planes, and the xyz coordinate system is the coordinate system in which an xy plane corresponds to the surface of the lead 3.

FIG. 8 is a table showing the coefficients of thermal expansion (unitx10⁻⁶ K⁻¹) in the directions of the crystal axes of the plane orientations, respectively. For example, in the case of a crystal structure in which the plane orientation (001) is parallel to the xy plane, the coefficient of thermal expansion αx in the x-axis direction is 15.80 (x10⁻⁶ K⁻¹), and the coefficient of thermal expansion αy in the y-axis direction is 15.80 (x10⁻⁶ K⁻¹). Also, the coefficient of thermal expansion αz in the z-axis direction is 28.40 (x10⁻⁶ K⁻¹). Therefore, the average value α (=(α1+α2)/2) of the coefficients of thermal expansion in the xy plane is 15.80 (x10⁻⁶ K⁻¹), and it can be understood that it is smaller than the coefficient of thermal expansion of copper 17.2 (x10⁻⁶ K⁻¹). Therefore, when tin is formed so that the (001) plane of tin is parallel to the surface of the lead 3, the coefficient of thermal expansion in the in-plane direction (xy plane) of the plating film 10 can be made lower than the coefficient of thermal expansion of copper constituting the lead 3. In other words, when the plating film 10 is comprised of single crystal of tin in which the plane parallel to the surface of the lead 3 is the (001) plane, the coefficient of thermal expansion in the in-plane direction of the plating film 10 can be made lower than the coefficient of thermal expansion in the in-plane direction of the lead 3. Consequently, even in the state in which thermal load of a high temperature is applied to the lead 3 on which the plating film 10 is formed, compressive stress does not act on the plating film 10, thereby preventing generation of whiskers in the plating film 10.

On the other hand, in the case of a crystal structure in which the plane orientation (220) is parallel to the xy plane, the coefficient of thermal expansion αx in the x-axis direction is 15.80 (x10⁻⁶ K⁻¹), and the coefficient of thermal expansion αy in the y-axis direction is 28.40 (x10⁻⁶ K⁻¹). Also, the coefficient of thermal expansion αz in the z-axis direction is 15.80 (x10⁻⁶ K⁻¹). Therefore, the average value α of the coefficients of thermal expansion in the xy plane is 22.10 (×10⁻⁶ K⁻¹), and it can be understood that it is larger than the coefficient of thermal expansion of copper 17.2 (x10⁻⁶ K⁻¹). Thus, forming tin so that the (220) plane of tin is parallel to the surface of the lead 3 cannot cause the coefficient of thermal expansion in the in-plane direction (xy plane) of the plating film 10 to be lower than the coefficient of thermal expansion of copper constituting the lead 3.

In this manner, it can be understood that the coefficient of thermal expansion in the in-plane direction (xy plane) of the plating film 10 have different numerical values depending on the plane orientations parallel to the surface of the lead 3. Therefore, when the plating film 10 is formed by the crystal structure in which the plane orientation, for example, (001), (101), or (112) is parallel to the surface of the lead 3 according to the table shown in FIG. 8, the coefficient of thermal expansion in the in-plane direction of the plating film 10 can be made lower than the coefficient of thermal expansion of the lead 3. Particularly, in the crystal structure in which the (001) plane is parallel to the surface of the lead 3, the coefficient of thermal expansion in the in-plane direction (xy plane) of the plating film 10 is the lowest; therefore, it can be understood that this is a desirable crystal structure from the viewpoint of causing the coefficient of thermal expansion in the in-plane direction (xy plane) of the plating film 10 to be lower than the coefficient of thermal expansion of the lead 3.

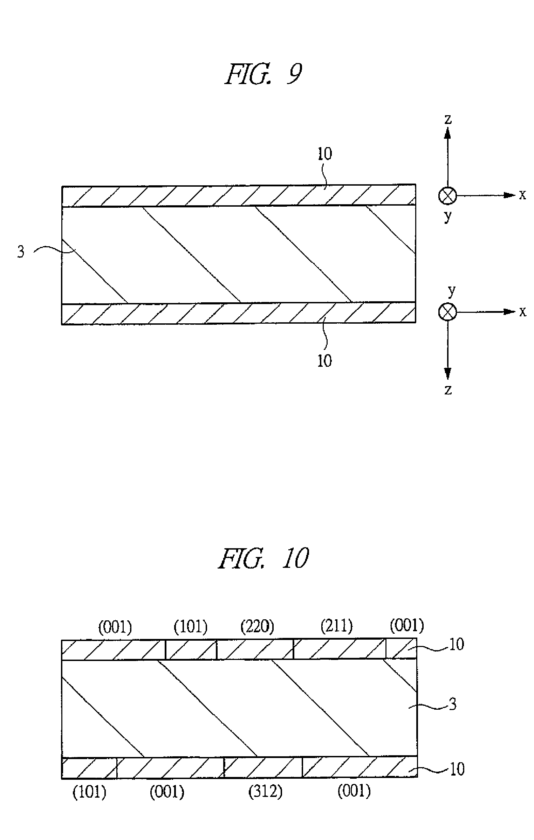

A summary of the above description is as described below. FIG. 9 is a cross-sectional view showing a cross section of the lead 3. As shown in FIG. 9, the plating film 10 is formed on the surface of the lead 3- Herein, in the case where a coordinate system which employs the surface of the lead 3 as the xy plane, one feature of the first embodiment lies in that the coefficient of thermal expansion in the in-plane direction of the plating film 10 can be caused to be lower than the coefficient of thermal expansion of the lead 3 by causing the plane orientation of tin parallel to the xy plane to be a particular plane orientation. The crystal structure of copper does not have anisotropy of coefficients of thermal expansion like the crystal structure of tin; therefore, the coefficient of thermal expansion of the lead 3 containing copper as a primary material is 17.2x10⁻⁶ K⁻¹. On the other hand, tin constituting the plating film 10 has anisotropy of coefficients of thermal expansion. Therefore, for example, when the plane orientation of tin parallel to the xy plane is caused to be the (001) plane, the coefficient of thermal expansion in the in-plane direction of the plating film 10 of tin becomes 15.80 (x10⁻⁶ K⁻¹); therefore, the coefficient of thermal expansion in the in-plane direction of the plating film 10 can be caused to be lower than the coefficient of thermal expansion of the lead 3. In other words, the single crystal having the plane orientation of tin parallel to the surface (xy plane) of the lead 3 being the (001) plane is employed as the crystal structure constituting the plating film 10, the coefficient of thermal expansion in the in-plane direction of the plating film 10 can be caused to be lower than the coefficient of thermal expansion of the lead 3. Herein, the single crystal in which the plane orientation of tin that is parallel to the surface (xy plane) of the lead 3 is the (001) plane has been described; however, similar effects can be obtained by a single crystal in which the coefficient of thermal expansion in the xy direction is lower than the coefficient of thermal expansion of copper like that having the (101) plane or (112) plane as the plane orientation of tin that is parallel to the surface (xy plane) of the lead 3.

In the foregoing description, the example in which, for example, the plating film 10 is comprised of the single crystal in which the plane orientation of tin that is parallel to the surface (xy plane) of the lead 3 is the (001) plane has been described. However, also in the case in which the plating film 10 is comprised of a polycrystal instead of constituting the plating film 10 by single crystal of tin, the coefficient of thermal expansion in the in-plane direction of the plating film 10 can be caused to be lower than the coefficient of thermal expansion of the lead 3 under certain conditions.

FIG. 10 shows an example in which the plating film 10 is comprised of a polycrystal of tin. In this case, as shown in FIG. 10, the plating film 10 is formed by grains having plane orientations of tin parallel to the surface (xy plane) of the lead 3 such as (001), (101), (220), (211), and (312). In this case, when a rate of the grains having the (hkl) plane that is parallel to the surface of the plating film 10 occupy the volume of the plating film 10 is x(hkl), and an average value of coefficients of thermal expansion in the in-plane direction (xy plane) of the plating film 10 is α(hkl), a coefficient of thermal expansion of the whole plating film 10 can be estimated to be x(h₁k₁l₁) × α(h₁k₁l₁) + x(h₂k₂l₂) × α(h₂k₂l₂)+ ...+ x (hₙkₙlₙ) × α(hₙkₙlₙ). Therefore, when the plating film 10 is formed so as to satisfy the inequality expression x(h₁k₁l₁) x α(h₁k₁l₁) + x(h₂k₂l₂) x α(h₂k₂l₂)+ ... + x(hₙkₙlₙ) x α(hₙkₙlₙ) ≤ 17.2x10⁻⁶ (rate of thermal expansion of copper), the coefficient of thermal expansion in the in-plane direction of the plating film 10 becomes lower than the coefficient of thermal expansion of copper. Note that, in the abovedescribed inequality expression, x(h₁k₁l₁) + x(h₂k_{z}l₂) + ... + x(hₙkₙlₙ₎ = 1 is satisfied.

Therefore, when the plating film 10 is formed by the polycrystal satisfying the abovedescribed inequality expression, compressive stress is not generated in the plating film 10 when it is at a high temperature; thus, generation of whiskers in the plating film 10 can be prevented. Particularly, the grains having the (001) plane being parallel to the surface of the plating film 10 have the lowest coefficient of thermal expansion (average value) in the surface of the plating film 10; therefore, it can be understood that the grains having this structure is the grains that are most effective under the conditions that satisfy the abovedescribed inequality expression. According to the foregoing, the plating film 10 satisfying the conditions according to the inequality expression can be formed by forming the plating film 10 so that the grains having the (001) plane, the (112) plane, or the (101) plane being parallel to the surface of the plating film 10 present in the plating film 10 as many as possible.

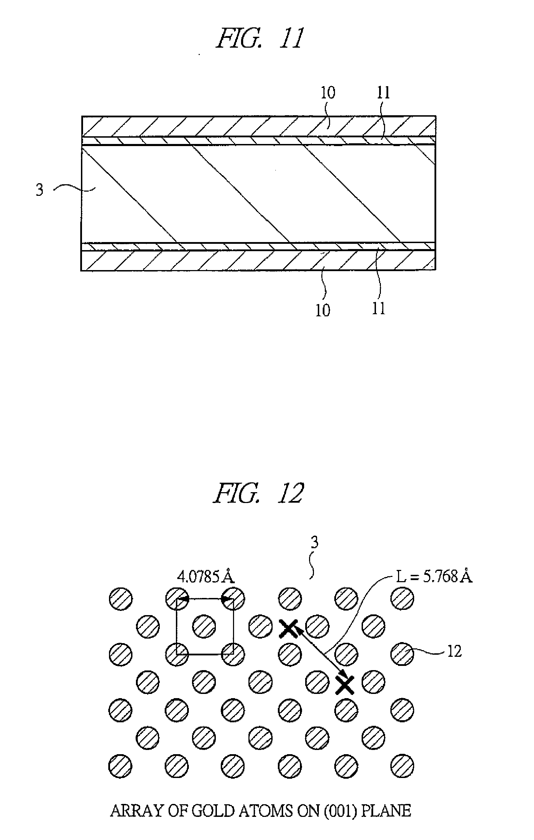

Next, a method of forming the plating film 10 so that the (001) plane of the plating film 10 is parallel to the in-plane direction of the lead 3 will be described. As shown in FIG. 11, first, a gold film 11 is formed on the surface of the lead 3 by an electrolytic plating method. Then, the plating film 10 containing tin as a primary material is formed on the gold film 11 by an electrolyte plating method. When the gold film 11 is formed between the plating film 10 containing tin as a primary material and the lead 3 in this manner, the (001) plane of the plating film 10 can be formed to be parallel to the in-plane direction of the lead 3.

Hereinafter, the mechanism that the (001) plane of the plating film 10 can be formed to be parallel to the in-plane direction of the lead 3 by forming the plating film 10 on the gold film 11 will be described. FIG. 12 is a plan view showing gold atoms 12 formed on the surface of the lead 3. As shown in FIG. 12, the gold film 11 comprising the gold atoms 12 is formed on the surface of the lead 3 by the electrolyte plating method. Herein, the gold film 11 is formed so that the (001) plane is parallel to the surface of the lead 3. In other words, in FIG. 12, the gold atoms 12 constituting the (001) plane of the gold film are arranged. The formation of the gold film 11 so that the (001) plane of the gold film is parallel to the surface of the lead 3 in this manner can be realized by, for example, adjusting a current value, a temperature, and a composition of a plating solution in the electrolyte plating method for forming the gold film 11. For example, when the formation of the gold film 11 by the electrolyte plating method is carried out under an intermediate overvoltage condition, the gold atoms 12 can be formed so that the (001) plane is parallel to the surface of the lead 3. Details of this method are described in, for example, a reference (Journal of Electroanalytical Chemistry, Vol. 9, p 70, 1965).

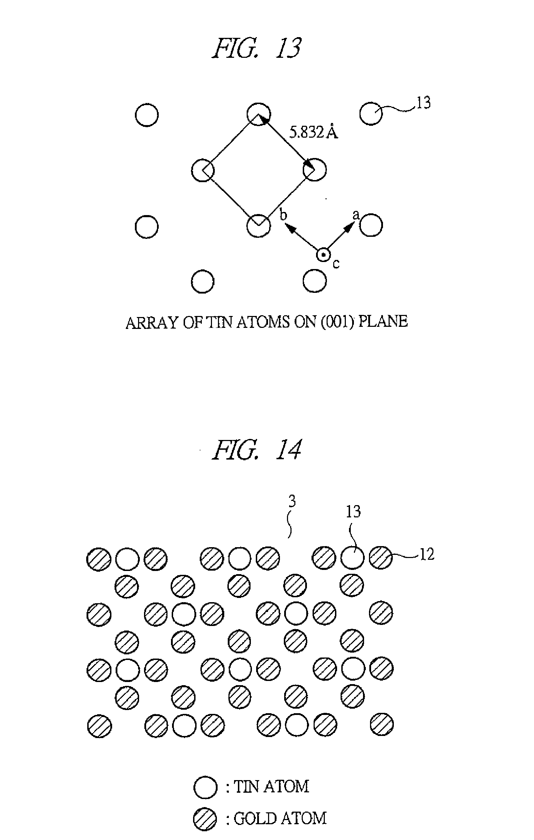

In FIG. 12, a lattice constant of the gold atoms 12 constituting the (001) plane of the gold film 11 is 4.0785 Å, and a distance of a spacing L shown in FIG. 12 is 5.768 Å. Subsequently, tin atoms are formed on the gold film 11. FIG. 13 is a diagram showing an array of tin atoms 13 on the (001) plane of the plating film 10 containing tin as a primary material. A lattice constant of the tin atoms 13 in the (001) plane is 5.832 Å. Therefore, the spacing L (5.768 Å) shown in FIG. 12 and the lattice constant (5.832 Å) of the tin atoms 13 shown in FIG. 13 have substantially equal values; thus, the (001) plane of tin readily grows on the (001) plane of the gold film. Thus, in an interface of the (001) plane of the gold film 11 and the (001) plane of tin, the gold atoms 12 and the tin atoms 13 are arranged as shown in FIG. 14.

As shown in FIG. 14, when a plating film 10 containing tin as a primary material is to be formed on the gold film 11, the gold atoms 12 are arranged so as to constitute the (001) plane, and the tin atoms 13 are disposed so as to be just fit in the space not filled with the gold atoms 12. In this process, the tin atoms 13 are disposed in the space where the gold atoms 12 are not disposed, and the spacing L of this space is substantially equal to the lattice constant of the (001) plane of tin. Therefore, the tin atoms 13 naturally grow on the gold film 11 so that the (001) plane of tin is parallel to the surface of the lead 3. In other words, the situation is such that the condition that the (001) plane of tin readily grows on the gold film 11 having the (001) plane. One feature of the first embodiment lies in finding out the point that the (001) plane of tin is readily formed on the gold film 11 when the gold film 11 is formed in the manner so that the (001) plane of the gold film 11 is parallel to the surface of the lead 3 by virtue of the relation of the array configuration of the gold atoms 12 and the lattice constant of the (001) plane of tin. Thus, the plating film 10 in which the (001) plane of tin is parallel to the surface of the lead 3 can be formed on the lead 3 via the gold film 11.

In the first embodiment, the example of forming the gold film 11 between the plating film 10 containing tin as a primary material and the lead 3 has been described; however, a silver film may be formed other than the gold film. More specifically, the (001) plane of the silver film also has a configuration similar to the (001) plane of the gold film, and the lattice spacing thereof is also similar. Therefore, when a plating film 10 containing tin as a primary material is formed on the silver film, tin atoms are disposed in the space where the silver atoms are not disposed. Herein, the point that the spacing of the space is approximately equal to the lattice constant of the (001) plane of tin is also similar to the gold film. Therefore, the tin atoms 13 can be caused to grow naturally on the silver film so that the (001) plane of tin is parallel to the surface of the lead 3.

In addition, the gold film may not be formed to entirely cover the lead 3 and may be partially formed on the lead 3. This is for the reason that the gold film 11 is used for forming the (001) plane of tin so that the plane is parallel to the surface of the lead 3. Thus, in the case where the plating film 10 containing tin as a primary component is comprised of a plurality of grains having different plane orientations parallel to the surface of the lead 3 (the case of polycrystal), the gold film 11 is merely required to be formed in the region where the grains having the (001) plane being parallel to the surface of the lead 3 are formed.

Moreover, when heat treatment is carried out after the plating film 10 is completed, and even when the gold atoms 12 constituting the gold film 11 disappear as diffused into the copper constituting the lead 3 or into the tin constituting the plating film 10, it is not problematic. This is for the reason that the gold film 11 is the film used for forming the (001) plane of tin so that the plane is parallel to the surface of the lead 3, and, after the plating film 10 is completed, the state that the (001) plane of tin is parallel to the surface of the lead 3 is maintained even when the gold film 11 disappears. Therefore, in some cases, the completed semiconductor device 1 may have a structure in which, even though the gold film 11 is formed on the lead, the gold film 11 is not present on the lead 3 and the plating film 10 containing tin as a primary material is directly formed thereon.

Next, a fabrication process of a semiconductor device according to the first embodiment will be described. The QFP has been described as the package mode of the first embodiment; however, in the fabrication process described below, a SOP (Small Outline Package), which is a package configuration of the surface mount type as well as the QFP, will be described. Basic fabrication steps are the same in the both cases in which the package configuration is the QFP or SOP.

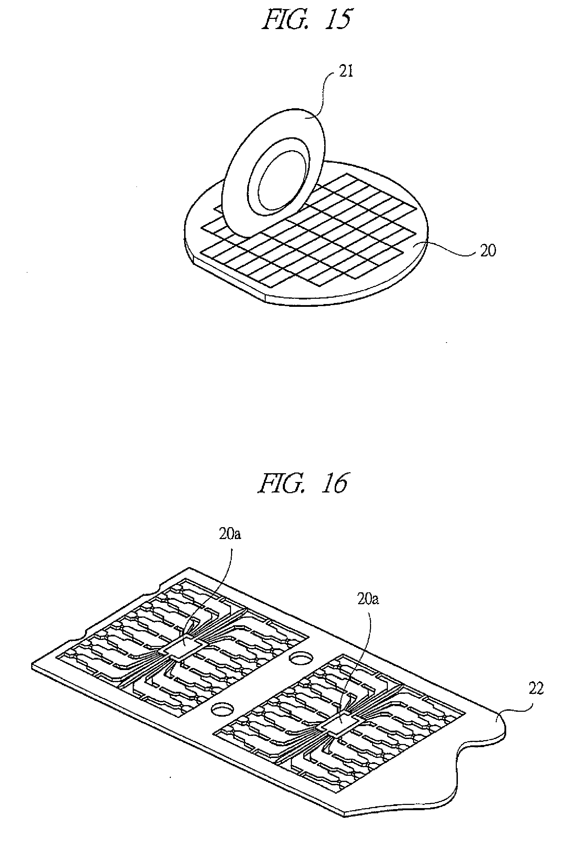

First, in FIG. 15, a semiconductor wafer 20 is prepared. The semiconductor wafer 20 is sectioned into a plurality of chip regions, where LSIs (Large Scale Integration Circuits) are formed on the plurality of chip regions, respectively. The LSIs are formed in a so-called wafer process (front end).

Subsequently, the semiconductor wafer 20 is cut by a blade 21. In other words, the semiconductor wafer 20 is cut in the chip region units, thereby obtaining semiconductor chips. Meanwhile, a lead frame 22 for mounting the semiconductor chips is prepared. The lead frame 22 contains, for example, copper as a primary material. Subsequently, a plating film is formed on surfaces of leads formed in the lead frame 22. In this plating step, the technical idea of the first embodiment is realized. For example, as described above, first, a gold film is formed on the surface of each lead by an electrolyte plating method. Then, a plating film containing tin as a primary material is formed on the gold film by the electrolyte plating method. When the gold film is formed between the plating film containing tin as a primary material and the lead, the (001) plane of the plating film can be formed so that the plane is parallel to the in-plane direction of the lead. In this plating process, the plating film can be formed by tin that is in a single-crystalline state in which the (001) plane is parallel to the in-plane direction of the lead or by tin that is in a polycrystalline state satisfying the abovedescribed inequality expression x(h₁k₁l₁ x α(h₁k₁l₁) + x(h₂k₂l₂) x α(h₂k₂l₂) + ... + x(hₙkₙlₙ) x α(hₙkₙlₙ) ≤ 17.2x10⁻⁶ (rate of thermal expansion of copper).

Then, as shown in FIG. 16, semiconductor chips 20a are mounted on tabs of the lead frame 22 in which lead patterns which has been subjected to the plating process are formed. Each semiconductor chip 20a is mounted on the tab formed on the lead frame 22 by a die bonder.

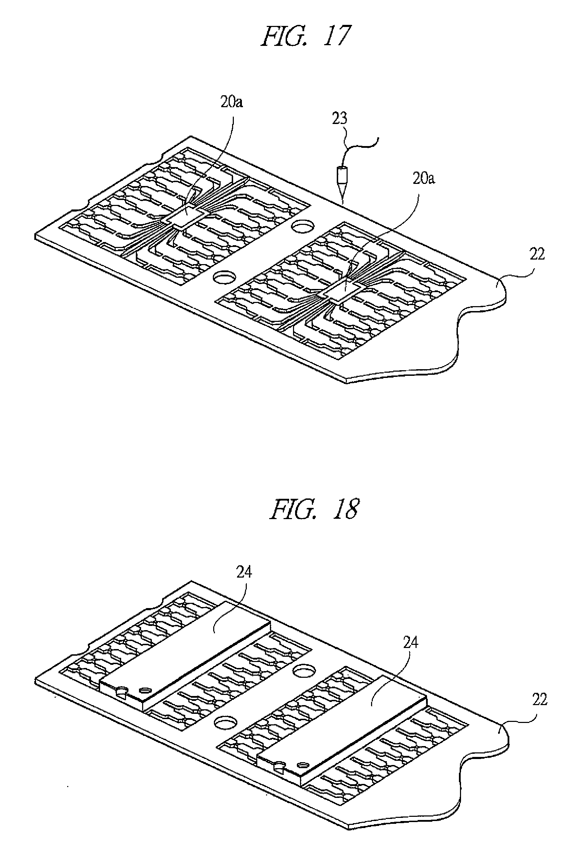

Next, as shown in FIG. 17, pads (not shown) formed on the semiconductor chip 20a mounted on the tab and the plurality of leads (inner leads) formed in the lead frame 22 are connected by wires 23. The wires 23 connect the pads and the leads by using a capillary.

Then, as shown in FIG. 18, the semiconductor chip 20a mounted on the lead frame 22 and the region including the inner leads are sealed by a resin 24. The sealing by the resin 24 is carried out in order to protect the semiconductor chip 20a from impact caused by external force and penetration of moisture.

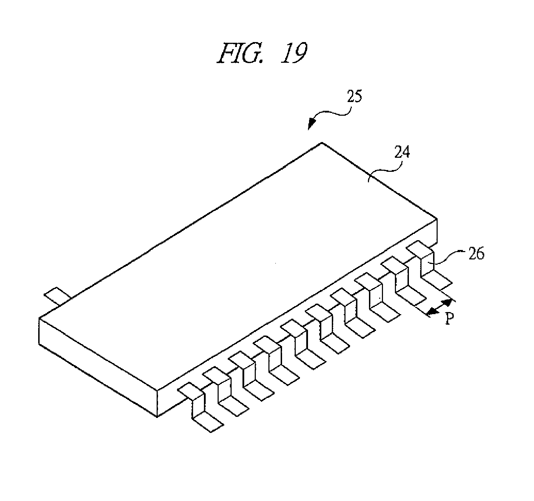

Next, the sealant body sealed by the resin 24 is separated into pieces from the lead frame 22. Thus, a semiconductor device 25 shown in FIG. 19 can be obtained. The semiconductor device 25 comprises the sealant body sealed by the resin 24 and leads (outer leads) 26 projecting from the sealant body. The plating film (not shown) is formed on the surface of each of the leads 26 projecting from the sealant body.

According to the first embodiment, the coefficient of thermal expansion in the in-plane direction of the plating film (tin) formed on the surface of the lead 26 can be made to be lower than a coefficient of thermal expansion of the lead 26 (copper). Therefore, even in the state in which thermal load of a high temperature is applied to the lead 26 on which the plating film is formed, compressive stress does not act on the plating film, thereby preventing generation of whiskers in the plating film. Meanwhile, when the coefficient of thermal expansion in the in-plane direction of the plating film (tin) is caused to be lower than the coefficient of thermal expansion of the lead 26 (copper), compressive stress acts on the plating film when thermal load of a low temperature is applied. However, in the case of the low temperature, since diffusion of atoms does not readily occur, whiskers due to the compressive stress are not generated. In other words, the compressive stress in the case of a low temperature does not cause the problem of whisker generation.

As described above, according to the semiconductor device 25 according to the first embodiment, generation of whiskers in the plating film which is formed on the surface of the lead 26 can be prevented. In the case where whiskers are generated, when a spacing P between the adjacent leads 26 is narrowed, the adjacent leads 26 are electrically connected to each other via the whiskers, and a short-circuit malfunction occurs in the semiconductor device 25. On the other hand, in the first embodiment, whiskers are not generated in the plating film that is formed on the surface of the lead 26; therefore, the spacing P between the adjacent leads 26 can be narrowed. For example, the spacing P between the adjacent leads 26 can be made to be less than or equal to 0.5 mm, and increased pins of the semiconductor device 25 and miniaturization of the semiconductor device 25 can be achieved. In this manner, the semiconductor device 25 according to the first embodiment can be fabricated.

One feature of the first embodiment lies in the point that the coefficient of thermal expansion in the in-plane direction of the plating film containing tin as a primary material is caused to be lower than the coefficient of thermal expansion of copper constituting the lead. As a method of actually realizing this structure, the plane orientation of tin that is parallel to the in-plane direction of the plating film is caused to be a particular plane orientation so as to realize it. For example, when the plating film is formed by a polycrystal of tin, individual grains are required to be formed so as to satisfy the abovedescribed inequality expression x(h₁k₁l₁) x α(h₁k₁l₁) + x(h₂k₂l₂) x α(h₂k₂l₂) + ... + x(hₙkₙlₙ) x α(hₙkₙlₙ) ≤ 17.2x10⁻⁶ (rate of thermal expansion of copper). In the case where the plating film is formed by a polycrystal of tin in this manner, with regard to whether the constitution according to the first embodiment is used or not, some sort of a verification method is required. Hereinafter, a method of verification whether the plating film serving as an inspection object actually satisfies the abovedescribed inequality expression will be described.

In analysis of the crystal structure, generally, the X-ray diffraction measurement is used. In the X-ray diffraction measurement, when a crystal is irradiated with X rays, the X rays are diffracted due to regularly arranged individual atoms, and variations appear in the intensity of the X rays exited from the crystal by the diffraction phenomenon, where the intensities are mutually enhanced at some location, while the intensities are mutually weakened at some other location. The crystal structure can be analyzed by observing the variations.

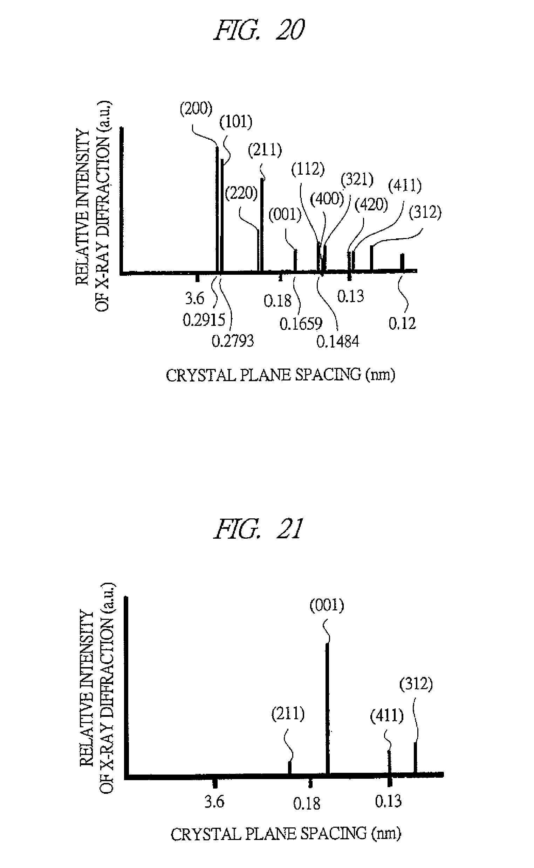

FIG. 20 shows a result of carrying out the X-ray diffraction measurement of a tin crystal in a powdery state in which a plurality of plane orientations randomly exist. In FIG. 20, the horizontal axis represents crystal plane spacing, and the vertical axis represents relative intensity of X-ray diffraction. As shown in FIG. 20, spectra having a plurality of peaks are detected as the relative intensity of X-ray diffraction. When the crystal plane spacing for which the spectra are detected is examined, it can be found out which plane orientations the spectra are representing. The tin crystal in the powdery state is on the assumption that grains having different plane orientations are equally contained. Therefore, in FIG. 20, although the degrees of the spectra are different, this does not mean that the grains having a certain plane orientation are contained a lot. In other words, the degrees of the detected spectra are different depending on the plane orientations. For example, it can be understood that the spectrum intensity of the (200) plane tends to be strong and that the spectrum intensity of the (001) plane tends to be weak. Specifically, when the relative intensity of X-ray diffraction of the crystal planes (plane orientations) is expressed so that the intensity of the (200) plane is expressed as 100, the intensity of the (101) plane is 90, the intensity of the (220) plane is 34, the intensity of the (211) plane is 74, the intensity of the (001) plane is 17, the intensity of the (112) plane is 23, the intensity of the (400) plane is 13, the intensity of the (321) plane is 20, the intensity of the (420) plane is 15, the intensity of the (411) plane is 15, and the intensity of the (312) plane is 20.

Next, FIG. 21 shows a result of actually carried out the X-ray diffraction measurement on a plating film formed on a lead. As shown in FIG. 21, it is shown that four planes, the (211) plane, the (001) plane, the (411) plane, and the (312) plane are detected as the plane orientations that are parallel to the surface of the lead. Note that, it cannot be said that each of the intensities of X-ray diffraction shown in FIG. 21 represents each rate of the grains having the respective plane orientations. This is for the reason that, even when grains having different plane orientations are contained in the same rate, the relative intensity of X-ray diffraction is different in each plane orientation as described in FIG. 20. Therefore, in order to calculate the rates of the grains having different plane orientations from the measurement result shown in FIG. 21, quantification is required to be carried out with the measurement result shown in FIG. 20.

In the measurement result of FIG. 21, when the intensity of the (001) plane is 100, the intensity of the (211) plane is 7.4, the intensity of the (001) plane is 100, the intensity of the (411) plane is 15, and the intensity of the (312) plane is 20. When the data is divided by the measurement result of the tin in the powdery state shown in FIG. 20, the intensity of the (211) plane is 7.4/74 = 0.1, the intensity of the (001) plane is 100/17 = 5.88, the intensity of the (411) plane is 15/15 = 1, and the intensity of the (312) plane is 20/20 = 1. These values obtained by the division represent the rates of the grains contained in the plating film and having different plane orientations. Furthermore, standardization is carried out so that the relative intensities of X-ray diffraction of the four plane orientations become 1 in total. Thus, x(hkl) in the inequality expression can be obtained by dividing the intensity by 7.98(0.1+5.88+1+1) which is the total of the intensities. Specifically, x(211) is 0.0125, x(001) is 0.737, x(411) is 0.125, and x(312) is 0.125. Then, by using the values shown in FIG. 8, x(211) x α(211) + x(001) x α(001) + x(411) x α(411) + x(312) x α(312) = 16.9x10⁻⁶ is calculated, and it can be understood that this value is smaller than the rate of thermal expansion of copper 17.2x10⁻⁶. By utilizing the measurement results of the relative intensity of X-ray diffraction in the abovedescribed manner, whether the plating film serving as the inspection object actually satisfies the abovedescribed inequality expression or not can be confirmed. As is understood from the abovedescribed examples, a plating film in which the plane orientation parallel to the surface of the lead contains many (001) planes has the effect of reducing the coefficient of thermal expansion in the surface of the plating film. In order to inspect whether the plane orientation parallel to the surface of the lead contains many (001) planes or not, it can be determined when the relative intensity of X-ray diffraction is larger. Particularly, when the peak of the relative intensity of X-ray diffraction of the (001) plane is the highest, the effect of reducing the coefficient of thermal expansion in the surface of the plating film becomes remarkable.

The position where the relative intensity of X-ray diffraction corresponding to the (001) plane appears is somewhat varied by a strain of the crystal structure in some cases, and it appears between the crystal plane spacing of 0.16 nm to 0.18 nm.

### (Second Embodiment)

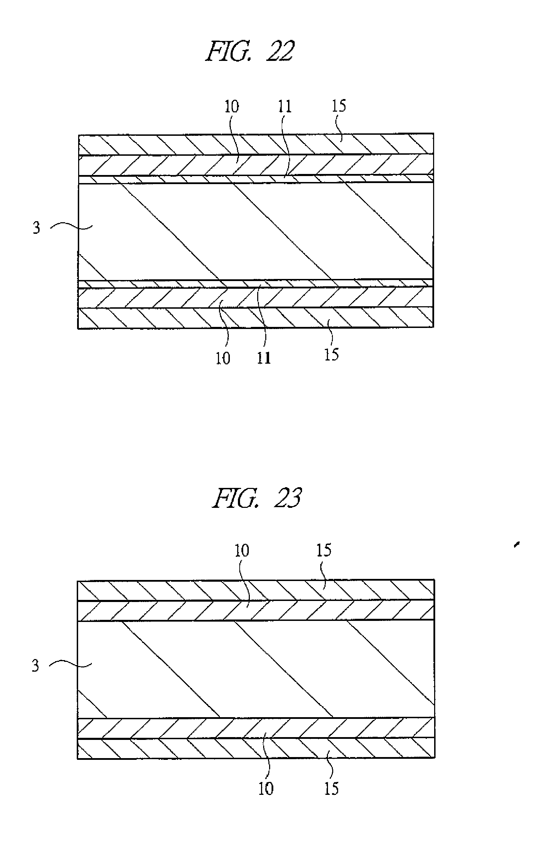

In a second embodiment, an example in which a plating film formed on a surface of a lead has a multi-layered structure will be described. FIG. 22 is a cross-sectional view showing a constitution of the plating film formed on the lead 3 in a semiconductor device according to the second embodiment. In FIG. 22, the gold film 11 is formed on the surface of the lead 3, and the plating film 10 containing tin as a primary material is formed on the gold film 11. The plating film 10 serves as a first plating layer, and a plating film 15 containing tin as a primary material is further formed on the plating film 10. In this manner, in the second embodiment, the multilayered film comprising the plating film 10 and the plating film 15 is formed on the gold film 11.

Herein, the gold film 11 has a function of controlling the crystal plane (plane orientation) of the plating film 10 formed on the gold film 11 to be in a particular direction. Specifically, as described in the abovedescribed first embodiment, the (001) plane of the gold film 11 is formed to be parallel to the surface of the lead 3, and the plating film 10 formed on the gold film 11 is formed so that the (001) plane of tin is parallel to the surface of the lead 3.

Thus, the coefficient of thermal expansion in the in-plane direction of the plating film 10 can be lower than the coefficient of thermal expansion of the lead 3. More specifically, when the crystal structure constituting the plating film 10 is a single crystal in which the plane orientation of tin parallel to the surface of the lead 3 is the (001) plane, the coefficient of thermal expansion in the in-plane direction of the plating film 10 can be lower than the coefficient of thermal expansion of the lead 3.

Furthermore, the plating film 10 may be formed by a polycrystal instead of forming it by the single crystal of tin. Specifically, as well as the abovedescribed first embodiment, when the rate of the grains having a (hkl) plane is parallel to the surface of the plating film 10 occupies the volume of the plating film 10 is x(hkl), and the average value of thermal expansion coefficients of the plating film 10 in the in-plane direction (xy plane) is α(hkl), the coefficient of thermal expansion of the whole plating film 10 can be estimated to be x(h₁k₁l₁) x α(h₁k₁l₁₎ + x(h₂k₂l₂) x α(h₂k₂l₂) + ··· + x(hₙkₙlₙ) x α(hₙkₙlₙ). Therefore, when the plating film 10 that satisfies the inequality expression x(h₁k₁l₁) x α(h₁k₁l₁) + x(h₂k₂l₂) x α(h₂k₂l₂) + ... + x(hₙkₙlₙ) x α(hₙkₙlₙ) ≤ 17.2x10⁻⁶ (rate of thermal expansion of copper) is formed, the coefficient of thermal expansion in the in-plane direction of the plating film 10 can be lower than the coefficient of thermal expansion of copper.

Next, the plating film 15 formed on the plating film 10 may have a similar constitution as the plating film 10 or may have a different constitution. However, it is preferred that the plating film 15 also has a coefficient of thermal expansion in the in-plane direction lower than the coefficient of thermal expansion of copper. This is for the reason that, in the plating film 15, for example, if the rate of thermal expansion in the in-plane direction of the plating film 15 is higher than the rate of thermal expansion of copper, compressive stress is generated in the plating film 15 and serves as a cause of generation of whiskers. Therefore, although the plating film 15 is not required to have a similar constitution as the plating film 10, it is preferred that the plating film 15 has a constitution that satisfies the abovedescribed inequality expression, thereby causing the coefficient of thermal expansion in the in-plane direction of the plating film 15 is lower than the coefficient of thermal expansion of copper. Specifically, the plating film 15 can be also constituted by a single crystal in which the plane orientation of tin parallel to the surface of the lead 3 is, for example, the (001) plane, the (101) plane, and the (112) plane; alternatively, the plating film 15 may be constituted by a polycrystal containing a lot of grains having a plane orientation parallel to the surface of the plating film 15 is, for example, the (001) plane, the (101) plane, and the (112) plane.

Note that, as well as the abovedescribed first embodiment, the gold film 11 is not required to be formed to entirely cover the lead 3 and may be partially formed on the lead 3. This is for the reason that the gold film 11 is used for forming the (001) plane of tin so that the plane of tin is parallel to the surface of the lead 3. Thus, in the case where the plating film containing tin as a primary component is comprised of a plurality of grains having different plane orientations parallel to the surface of the lead (the case of polycrystal), the gold film 11 is merely required to be formed in the region where the grains having the (001) plane being parallel to the surface of the lead 3 are formed.

Furthermore, when heat treatment is carried out after the plating film 10 is completed, and even when the gold atoms 12 constituting the gold film 11 disappear as diffused into the copper constituting the lead 3 or into the tin constituting the plating film 10, it is not problematic. This is for the reason that the gold film 11 is the film used for forming the (001) plane of tin so that the plane of tin is parallel to the surface of the lead 3, and, after the plating film 10 is completed, the state that the (001) plane of tin is parallel to the surface of the lead 3 is maintained even when the gold film 11 disappears. Therefore, as shown in FIG. 23, in some cases, in the formed structure, even though the gold film 11 had been formed on the lead 3, the gold film 11 is not present on the lead 3 and the plating film 10 containing tin as a primary material is directly formed on the lead 3.

In the foregoing, the invention made by the inventors of the present invention has been concretely described based on the embodiments. However, it is needless to say that the present invention is not limited to the foregoing embodiments and various modifications and alterations can be made within the scope of the present invention.

The present invention can be widely utilized in the manufacturing industry for fabricating semiconductor devices.

### Additional features of the invention are discussed in the following clauses:

1. A semiconductor device comprising:
   (a) a semiconductor chip;
   (b) a plurality of leads electrically connected with the semiconductor chip and containing copper as a primary material;
   (c) a plating film formed on a surface of each of the plurality of leads, and the plating film containing tin as a primary material and not containing lead; and
   (d) a sealant member for sealing the semiconductor chip, wherein
      part of each of the plurality of leads is exposed from the sealant member, and
      a coefficient of thermal expansion in an in-plane direction of the plating film is lower than a coefficient of thermal expansion of the copper.
2. The semiconductor device according to clause 1, wherein
   the tin constituting the plating film is a polycrystal having a plurality of grains; and
   the plurality of grains include a grain having a (001) plane being parallel to the surface of the plating film.
3. The semiconductor device according to clause 2, wherein
   when a rate of grains having a (hkl) plane being parallel to the surface of the plating film occupy the volume of the plating film is x(hkl), and an average value of the coefficients of thermal expansion in the in-plane direction of the plating film of the grains having the (hkl) plane being parallel to the surface of the plating film is α(hkl), x(h₁k₁l₁) x α(h₁k₁l₁) + x(h₂k₂l₂)xα(h₂k₂l₂) + ... + x(hₙkₙlₙ)xα(hₙkₙlₙ) ≤ 17.2×10⁻⁶ (where, x(h₁k₁l₁) + x(h₂k₂l₂) + ... + x(hₙkₙlₙ) = 1) is satisfied.
4. The semiconductor device according to clause 2, wherein
   a gold film or a silver film is formed between the plurality of leads and the plating film.
5. The semiconductor device according to clause 4, wherein
   the gold film or the silver film is formed so that a (001) plane is parallel to the surface of the plating film.
6. The semiconductor device according to clause 1, wherein,
   when a crystal structure is analyzed by using X-ray diffraction with respect to the plating film, an intensity peak obtained by X-ray diffraction appears between 0.16 nm and 0.18 nm of a value of crystal plane spacing.
7. The semiconductor device according to clause 6, wherein
   the intensity peak that appears between 0.16 nm to 0.18 nm of the value of crystal plane spacing is the highest peak.
8. A semiconductor device comprising:
   (a) a semiconductor chip;
   (b) a plurality of leads electrically connected with the semiconductor chip and containing copper as a primary material;
   (c) a plating film formed on a surface of each of the plurality of leads, and the plating film containing tin as a primary material and not containing lead; and
   (d) a sealant member for sealing the semiconductor chip, wherein
      part of each of the plurality of leads is exposed from the sealant member, and
      the plating film comprises a film having a coefficient of thermal expansion in an in-plane direction of the plating film lower than a coefficient of thermal expansion of the copper.
9. The semiconductor device according to clause 8, wherein
   the film contained comprised in the plating film and having the coefficient of thermal expansion in the in-plane direction that is lower than the coefficient of thermal expansion of the copper is in direct contact with each of the plurality of leads.
10. A fabrication process of a semiconductor device comprising the steps of:
   (a) preparing a lead frame containing copper as a primary material;
   (b) forming a plating film containing tin as a primary material and not containing lead on a surface of each of a plurality of leads formed to the lead frame;
   (c) mounting a semiconductor chip on a tab of the lead frame;
   (d) connecting the semiconductor chip with the plurality of leads formed to the lead frame by wires;
   (e) forming a sealant member by sealing the semiconductor chip; and
   (f) cutting the lead frame to separate the sealant body into pieces, wherein
      the plating film is formed so that a coefficient of thermal expansion in an in-plane direction of the plating film is lower than a coefficient of thermal expansion of the copper constituting the plurality of leads.
11. The fabrication process of the semiconductor device according to clause 10, wherein
   the tin constituting the plating film is a polycrystal having a plurality of grains; and
   the plating film is formed so that the plurality of grains contain a grain having a (001) plane being parallel to the surface of the plating film.
12. The fabrication process of the semiconductor device according to clause 11, wherein
   a rate of the grains having a (hkl) plane being parallel to the surface of the plating film occupy the volume of the plating film is x(hkl), and an average value of the coefficients of thermal expansion in the in-plane direction of the plating film of the grains having the (hkl) plane being parallel to the surface of the plating film is α(hkl), the plating film is formed to satisfy x(h₁k₁l₁) x α(h₁k₁l₁) + x(h₂k₂l₂) x α(h₂k₂l₂) + ... + x(hₙkₙlₙ) x α(hₙkₙlₙ) ≤ 17.2x10⁻⁶ (where, x(h₁k₁l₁ + x(h₂k₂l₂) + ... + x(hₙkₙlₙ) = 1).
13. The fabrication process of the semiconductor device according to clause 10, wherein
   the step (b) includes the steps of:
   (b1) forming a gold film or a silver film on the surface of each of the plurality of leads formed to the lead frame; and
   (b2) forming the plating film containing tin as a primary material and not containing lead on the gold film or the silver film after the step (b1).
14. The fabrication process of the semiconductor device according to clause 13, wherein,
   in the step (b1), the gold film or the silver film is formed under a condition such that the (001) plane is parallel to the surface of the plating film.

## Claims

1. A semiconductor device (1) comprising:
(a) a semiconductor chip (5);
(b) a plurality of leads (3) electrically connected with the semiconductor chip (5) and containing copper as a primary material;
(c) a plating film (10) formed on a surface of each of the plurality of leads (3), and the plating film (10) containing tin as a primary material and being lead-free; and
(d) a sealant member (2) for sealing the semiconductor chip (5), part of each of the plurality of leads (3) being exposed from the sealant member (2),
**characterised in that**:
the tin constituting the plating film (10) is a polycrystal having a plurality of grains,
the plurality of grains include a grain having a (001) plane of the plating film (10),
a coefficient of thermal expansion in an in-plane direction of the plating film (10) is lower than a coefficient of thermal expansion of the copper, and a film functioning to make the (001) plane of the plating film (10) be parallel to a surface of each of the plurality of leads is formed between each of the plurality of leads (3) and the plating film (10).

2. The semiconductor device according to claim 1, wherein
when a rate of grains having a (hkl) plane being parallel to the surface of the plating film (10) occupy the volume of the plating film (10) is x (hkl), and an average value of the coefficients of thermal expansion in the in-plane direction of the plating film (10) of the grains having the (hkl) plane being parallel to the surface of the plating film is α(hkl), x(h₁k₁l₁) X α(h₁k₁l₁) + α(h₂k₂l₂) X α(h₂k₂l₂) + ... + x(hₙkₙlₙ) X α (hₙkₙlₙ) ≤ 7.2 X 10⁻⁶ K⁻¹ (where,
x(h₁k₁l₁) + x(h₂k₂l₂) + ... + x(hₙkₙlₙ) = 1) is satisfied.

3. The semiconductor device according to claim 1, wherein
the film functioning to make the (001) plane of the plating film be parallel to the surface of each of the plurality of leads is a gold film or a silver film.

4. The semiconductor device according to claim 1, wherein,
when a crystal structure is analyzed by using X-ray diffraction with respect to the plating film (10), an intensity peak obtained by X-ray diffraction appears between 0.16 nm and 0.18 nm of a value of crystal plane spacing.

5. The semiconductor device according to claim 4, wherein
the intensity peak that appears between 0.16 nm and 0.18 nm of the value of crystal plane spacing is the highest peak.

6. A fabrication process of a semiconductor device comprising the steps of:
(a) preparing a lead frame (22) containing copper as a primary material;
(b) forming a film functioning to make a (001) plane of a plating film (10) be parallel to a surface of each of the plurality of leads (3) on the surface of each of the plurality of leads (3) formed to the lead frame (22);
(c) forming the plating film containing tin as a primary material and being lead-free on the film functioning to make the (001) plane of the plating film be parallel to the surface of each of the plurality of leads after the step (b);
(d) mounting a semiconductor chip (5) on a tab (20a) of the lead frame (22);
(e) connecting the semiconductor chip with the plurality of leads (3) formed to the lead frame (22) by wires;
(f) forming a sealant member (2) by sealing the semiconductor chip (5); and
(g) cutting the lead frame (22) to separate the sealant member into pieces,
**characterised in that**:
the tin constituting the plating film (10) is a polycrystal having a plurality of grains,
the step (c) forms the plating film (10) so that the plurality of grains contain grains having a (001) plane of the plating film (10),
whereby the plating film (10) is formed so that a coefficient of thermal expansion in an in-plane direction of the plating film (10) is lower than a coefficient of thermal expansion of the copper constituting the plurality of leads (3).

7. The fabrication process of the semiconductor device according to claim 6, wherein
a rate of the grains having a (hkl) plane being parallel to the surface of the plating film (10) occupy the volume of the plating film is x(hkl), and an average value of the coefficients of thermal expansion in the in-plane direction of the plating film (10) of the grains having the (hkl) plane being parallel to the surface of the plating film is α(hkl), the plating film is formed to satisfy x(h₁k₁l₁) X α(h₁k₁l₁) + x(h₂k₂l₂) X α(h₂k₂l₂) + ... + x(hₙkₙlₙ) X α(hₙkₙlₙ) ≤17.2 X 10⁻⁶ K⁻¹ (where, x(h₁k₁l₁) + x (h₂k₂l₂) + ... + x (hₙkₙlₙ) = 1).

8. The fabrication process of the semiconductor device according to claim 6, wherein
the film functioning to make the (001) plane of the plating film be parallel to the surface of each of the plurality of leads is a gold film or a silver film.
